# EUROPEAN PATENT SPECIFICATION

(11) **EP 1 862 505 B1**
(45) Date of publication and mention of the grant of the patent: **25.04.2012**
(21) Application number: 07109207.6
(22) Date of filing: 30.05.2007
(51) Int. Cl.: C08L 51/00, C08L 51/04, C08L 51/06, C08F 255/00, C08F 279/02, C08F 287/00, B32B 27/00, H05K 3/00, G03F 7/00, B32B 27/16

(54) **Resin composition for printed wiring board film and use thereof**
Harzzusammensetzung für eine Leiterplattenfolie und ihre Verwendung
Composition de résine pour film de carte à circuit imprimé et son utilisation

(30) Priority: 30.05.2006 JP 2006150528
(43) Date of publication of application: 05.12.2007
(73) Proprietor: NOF CORPORATION, Tokyo 150-0013 (JP)
(72) Inventor: Ohta, Toshihiro, Aichi-ken 470-2398 (JP); Sonoda, Kensaku, Aichi-ken 470-2398 (JP); Yamada, Tomiho, Aichi-ken 470-2398 (JP)
(74) Representative: Viering, Jentschura & Partner

(56) References cited:
- EP-A- 1 371 754
- EP-A- 1 384 752
- EP-A1- 0 953 608
- WO-A-01/68785
- WO-A-2005/120142
- JP-A- 2 103 215
- JP-A- 3 227 587
- JP-A- 6 184 406
- JP-A- 6 275 929
- JP-A- 7 142 830
- JP-A- 2001 135 939
- JP-A- 2003 268 190
- US-A1- 2003 022 995
- US-A1- 2004 249 073
- US-A1- 2005 148 732

## Description

The present invention relates to a thermoplastic resin composition for a printed wiring board film. The resin composition has excellent high frequency signal transmission characteristics and excellent flexibility and is applicable for manufacturing of flexible printed wiring boards and rigid flexible printed wiring boards.

In order to increase the information transmission rates, communication devices and electronics devices use signals in high-frequency bands of from megahertz bands to gigahertz bands. However, the higher the frequency of an electric signal is, the more transmission loss occurs. There has been demanded an electrical insulating material that is applicable for transmitting high-frequency signals such as in gigahertz bands and that has excellent high frequency signal transmission characteristics. The transmission loss of a circuit contacted with an insulating material includes conductor loss that is determined by the shape, the skin resistance, and the characteristic impedance of the circuit (conductor); and dielectric material loss that is determined by the dielectric characteristics of an insulating layer (dielectric) around the circuit. The transmission loss may be radiated as the dielectric material loss from high-frequency circuits, and may be a factor that causes malfunctions of electronics devices. The dielectric material loss increases in proportion to the product of dielectric constant (ε) and dielectric loss (tanδ) of a material. In order to decrease the dielectric material loss, it is necessary to use a material that has both small dielectric constant and small dielectric loss.

In recent years, in order to respond to demands of miniaturizing communication devices and electronics devices, circuits have been formed on films deformable flexibly or foldable. Bendable or foldable circuits can be placed even in movable parts of devices, whereby internal spaces of the devices can be used efficiently.

When an upper board and a lower board are stacked, a wire harness can be used for connecting electrically the upper board and the lower board. The wire harness includes electrical circuits formed on the flexible printed wiring board. As for materials for forming the flexible printed wiring board, electrical circuits can be formed on the materials, and the materials have folding endurance (bending endurance). Such materials to be used are, for example, polyimide, polyethylene terephthalate, polyethylene naphthalate. However, these materials to be used have high dielectric constant and high dielectric loss in high-frequency bands, thereby having a problem of noise, cross-talk, or generating heat.

As a material that has small dielectric constant and small dielectric loss, namely having excellent high frequency signal transmission characteristics, and is bendable and foldable, there are known polytetrafluoroethylene (see Japanese Patent Laid-Open Publication No. 11-087910A), and liquid crystal resins (see Japanese Patent Laid-Open Publication No. 09-23047A). The polytetrafluoroethylene particularly exhibits excellent high frequency signal transmission characteristics, however, has drawbacks of difficulties in processing and high cost. The liquid crystal resins are excellent in cost and processability, however, lacks high frequency signal transmission characteristics.

US 20030022995 discloses thermoplastic resin compositions comprising rubber-reinforced thermoplastic resin components (A1), (A2), and an ethylene-α-olefin copolymer component (B). EP0953608 discloses heat-resistant, low-dielectric polymer materials containing 2 or more polymers which can be in grafted form. US20040249073 discloses transparent rubber-modified copolymer resin compositions obtained by polymerising styrenic monomers in the presence of rubbery polymer. JP2003268196 discloses low-dielectric and heat resistant graft copolymer compositions.

WO99/10435 discloses modified polyolefin resins. The modified polyolefin resins are appropriate in terms of cost, processability and high frequency signal transmission characteristics, and thus have been expected as useful electrical insulating materials. However, the modified polyolefin resins according to WO99/10435 includes a graft copolymer comprising a nonpolar α-olefin polymer segment, a nonpolar conjugated diene polymer segment, and a vinyl aromatic polymer segment. The graft copolymer comprises a matrix formed with the α-olefin polymer segment and the conjugated diene polymer segment, and a graft chain formed with the vinyl aromatic polymer segment. There is a problem that cracks are easily generated by delamination at the interface between the segments and durability (folding endurance) is insufficient when the film is bent repeatedly.

The object of the present invention is to provide a resin composition having low dielectric constant, low dielectric loss, and high folding endurance and suitable for manufacturing a printed wiring board.

One aspect of the present invention is a resin composition for a printed wiring board film. The resin composition includes 80 to 99.5 mass % of a component (a) and 0.5 to 20 mass % of a component (b). The component (a) is a graft copolymer in which 15 to 40 parts by mass of an aromatic vinyl monomer are grafted to 60 to 85 parts by mass of a random or block copolymer composed of monomer units selected from nonpolar α-olefin monomers and nonpolar conjugated diene monomers wherein an amount of multifunctional aromatic vinyl monomer in the aromatic vinyl monomer (side chains) of the graft copolymer component (a) is 2 to 30 mass %. The component (b) is a graft copolymer in which 5 to 30 parts by mass of an aromatic vinyl monomer are grafted as side chain(s) to 70 to 95 parts by mass of a random or block copolymer composed of 60 to 90 mass % of a monomer unit, which is selected from nonpolar α-olefin monomers and nonpolar conjugated diene monomers polymerised with 10 to 40 mass % of an aromatic vinyl monomer unit.

Another aspect of the present invention is a flexible printed wiring board that includes a printed wiring board film including two major surfaces and made from the resin composition and a conductive layer laminated on at least one of the two major surfaces of the printed wiring board film.

A further aspect of the present invention is a rigid flexible printed wiring board that includes a prepreg including a first printed wiring board film, which is made from the resin composition, and a sheet-like, fiber-reinforced material thermal pressure adhered to the first printed wiring board film, and a flexible printed wiring board including a second printed wiring board film, which is made from the resin composition and includes two major surfaces, and a conductive layer laminated on at least one of the two major surfaces of the second printed wiring board film.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiment together with the accompanying drawings in which:
Fig. 1 is a cross-sectional view of a flexible printed wiring board including an electrical insulative resin film made of a resin composition according to a preferred embodiment of the present invention;
Fig. 2 is a cross-sectional view of a prepreg including an electrical insulative resin film made of a resin composition according to a preferred embodiment of the present invention; and
Fig. 3 is a cross-sectional view of a rigid flexible printed wiring board including a flexible board portion bridging rigid board portions according to the preferred embodiment of the present invention.

Hereinafter, resin compositions according to preferred embodiments of the present invention will be explained.

A resin composition according to the preferred embodiments is used for forming an electrical insulative resin film for a printed wiring board (hereinafter, referred to as a printed wiring board film). The resin composition comprises 80 to 99.5 mass % of a component (a); and 0.5 to 20 mass % of a component (b).

The component (a) is a graft copolymer in which 15 to 40 parts by mass of an aromatic vinyl monomer are grafted to 60 to 85 parts by mass of a random or block copolymer comprising monomer units selected from nonpolar α-olefin monomers and nonpolar conjugated diene monomers wherein an amount of multifunctional aromatic vinyl monomer in the aromatic vinyl monomer (side chains) of the graft copolymer component (a) is 2 to 30 mass%; and the component (b) is a graft copolymer in which 5 to 30 parts by mass of an aromatic vinyl monomer are grafted to 70 to 95 parts by mass of a random or block copolymer comprising 60 to 90 mass % of a monomer unit selected from nonpolar α-olefin monomers and nonpolar conjugated diene monomers polymerised with 10 to 40 mass % of an aromatic vinyl monomer unit.

The electrical insulative resin film formed with the resin composition is used for preparing a flexible printed wiring board or a rigid flexible printed wiring board. The flexible printed wiring board is manufactured by providing a conductive layer on either or both of the two surfaces of the electrical insulative resin film formed with the resin composition. When the rigid flexible printed wiring board is manufactured, first, the electrical insulative resin film and a sheet-like, fiber-reinforced material are subjected to thermal pressure adhesion to prepare a prepreg, and subsequently a flexible printed wiring board is bonded to the prepreg.

Next, each component of the resin composition will be described.

### <Graft copolymer (a)>

The graft copolymer (a) is prepared by grafting 15 to 40 parts by mass of an aromatic vinyl monomer to 60 to 85 parts by mass of a random or block copolymer comprising monomer units selected from nonpolar α-olefin monomers and nonpolar conjugated diene monomers, wherein an amount of multifunctional aromatic vinyl monomer in the aromatic vinyl monomer (side chains) of the graft copolymer (a) is 2 to 30 mass %.

Each constitutional unit of the graft copolymer (a), have structures substantially consisting of only hydrocarbon groups or hydrocarbon skeletons and do not include polar functional groups or polar skeletons having high dipole moment. Therefore, use of such monomers contributes to manufacturing of polymers with enhanced high frequency signal transmission characteristics. The graft copolymer (a) is considered to have a molecular shape in which domains, namely side chains, formed with the aromatic vinyl monomer unit having pi electron interactions are grafted to the main chain formed with the random or block copolymer comprising monomer units selected from nonpolar α-olefin monomers and nonpolar conjugated diene monomers. This graft structure enables the graft copolymer (a) to partially dissolve in solvents while the graft copolymer (a) does not turn into liquid with high flowability even in temperatures more than or equal to the melting point of the graft copolymer (a). Therefore, flow of the graft copolymer (a), namely sagging due to heat, is prevented.

As the nonpolar α-olefin monomers, ethylene, propylene, butene, octene, 4-methylpentene-1, 2,4,4-trimethylpentene-1, may be used. As the nonpolar conjugated diene monomers, 1,3-butadiene, 2-methyl-1,3-butadiene, may be used.

The main chain of the graft copolymer (a) (hereinafter, referred to as a first matrix polymer) is constituted of a random or block copolymer comprising monomer units selected from the nonpolar α-olefin monomers and the nonpolar conjugated diene monomers. The monomer units selected from nonpolar α-olefin monomers and nonpolar conjugated diene monomers may be a mixture of a nonpolar α-olefin monomer unit and a nonpolar conjugated diene monomer unit; a mixture of plural types of nonpolar α-olefin monomer units; or a mixture of plural types of nonpolar conjugated diene monomer units. The nonpolar conjugated diene monomer units in the first matrix polymer may be partially hydrogenated.

The side chain of the graft copolymer (a) is constituted of aromatic vinyl monomer. As the aromatic vinyl monomer, for example, monofunctional monomers such as styrene, p-methyl styrene, or p-ethyl styrene, or multifunctional monomers such as divinylbenzene may be used. Such monomers may be used alone or in combination of two or more monomers.

The ratio of the aromatic vinyl monomer in the graft copolymer (a) is 15 to 40 mass %, and preferably 25 to 35 mass %. The graft copolymer (a) having the aromatic vinyl monomer in the ratio of less than 15 mass % exhibits properties peculiar to α-olefin polymers or nonpolar conjugated diene polymers and extremely high flowability in temperatures more than or equal to the melting point. As a result, some efforts are required in maintaining the shape of the prepreg or controlling the thickness of the prepreg. On the other hand, the graft copolymer (a) having the aromatic vinyl monomer in the ratio of more than 40 mass % provides a brittle prepreg. As a result, it is difficult to process the prepreg into a molded article (for example, the electrical insulative resin film).

The amount of multifunctional aromatic vinyl monomer in the aromatic vinyl monomer (side chains) of the graft copolymer (a) is preferably 2 to 30 mass %, and more preferably 15 to 25 mass %. Too much ratio of multifunctional aromatic vinyl monomer in the aromatic vinyl monomer of side chains provides a brittle prepreg. As a result, it is difficult to process the prepreg into a molded article (for example, the electrical insulative resin film).

The molecular weight of the graft copolymer (a) is suitably defined as the flowability of the graft copolymer (a). The MFR value of the graft copolymer (a) is preferably 2 to 50 g/(10 min), and more preferably 5 to 15 g/(10 min). When the MFR value is less than 2 g/(10 min), a film having insufficient mechanical properties is formed. When the graft copolymer (a) has the MFR value more than 50 g/(10 min), it is difficult to form a polymer film that has sufficient affinity for a sheet-like, fiber-reinforced material and a conductive layer. Insufficient affinity of the polymer film deteriorates heat cycle resistance of a molded article (for example, a film for a printed wiring board) processed from the resin composition.

Preparation of the graft copolymer (a) will be described. The graft copolymer (a) can be manufactured by graft polymerization according to the chain transfer method or the ionizing radiation irradiation method. A preferred method is the impregnation graft polymerization method, which provides high graft efficiency, does not cause secondary aggregation due to heat, easily realizes desired properties, and is convenient.

Manufacturing of the graft copolymer (a) according to the impregnation graft polymerization method will be described.

First, at least one monomer selected from nonpolar α-olefin monomers and nonpolar conjugated diene monomers is polymerized to prepare a homopolymer or copolymer (i.e., the first matrix polymer). 100 parts by mass of the first matrix polymer is suspended in water to prepare an aqueous suspension.

One, two or more radical copolymerizable organic peroxides, and a radical polymerization initiator in which the temperature at which half of the initiator decomposes for 10 hours (the 10-hour half life temperature) is 40 to 90 degrees Celsius are dissolved in 5 to 400 parts by mass of an aromatic vinyl monomer to prepare a solution of the aromatic vinyl monomer. The radical copolymerizable organic peroxides are controlled to be 0.1 to 10 parts by mass to 100 parts by mass of the aromatic vinyl monomer. The radical polymerization initiator is controlled to be 0.01 to 5 parts by mass to 100 parts by mass of the total of the aromatic vinyl monomer and the radical copolymerizable organic peroxides.

The solution of the aromatic vinyl monomer is mixed with the aqueous suspension so that the radical copolymerizable organic peroxides are impregnated into (absorbed by) each suspended particle of the first matrix polymer. In each suspended particle of the first matrix polymer, islands of the absorbed radical copolymerizable organic peroxides are dispersed. This aqueous suspension is heated under conditions that the radical polymerization initiator substantially does not decompose to' copolymerize the aromatic vinyl monomer and the radical copolymerizable organic peroxides in the particles of the first matrix polymer to prepare a grafted precursor.

The grafted precursor is melted and kneaded at 100 to 300 degrees Celsius to prepare the target graft copolymer.

Alternatively, the graft copolymer may be prepared by mixing the grafted precursor with a polymer or copolymer, which is different from the first matrix polymer, derived from at least one monomer selected from nonpolar α-olefin monomers and nonpolar conjugated diene monomers or a polymer derived from an aromatic vinyl monomer; and melting and kneading the mixture at 100 to 300 degrees Celsius.

The radical copolymerizable organic peroxides are molecules that have both properties of radical copolymerizable monomers and properties of organic peroxides. Examples of the radical copolymerizable organic peroxides may include: t-butyl peroxyacryloyloxyethyl carbonate, t-butyl peroxymethacryloyloxyethyl carbonate, t-butyl peroxyallyl carbonate, t-butyl percxymethallyl carbonate, and the like. A preferred radical copolymerizable organic peroxide is t-butyl peroxymethacryloyloxyethyl carbonate.

### <Graft copolymer (b)>

The graft copolymer (b) is prepared by grafting 5 to 30 parts by mass of an aromatic vinyl monomer to 70 to 95 parts by mass of a random or block copolymer (hereafter, referred to as a second matrix polymer) comprising 60 to 90 mass % of a monomer unit selected from nonpolar α-olefin monomers and nonpolar conjugated diene monomers polymerised with 10 to 40 mass % of an aromatic vinyl monomer unit.

The second matrix polymer is a random or block copolymer, and contains 10 to 40 mass % of an aromatic vinyl monomer. When the ratio of the aromatic vinyl monomer is more than 40 mass %, the graft copolymer (b) that lacks flowability is prepared. Such a graft copolymer (b) is hard to be compatible with the graft copolymer (a) even by kneading the graft copolymer (b) with the graft copolymer (a). On the other hand, when the ratio of the aromatic vinyl monomer is less than 10 mass %, the graft copolymer (b) has extremely high flowability. A resin composition prepared by using such a graft copolymer (b) liquefies at the time of being subjected to thermal pressure adhesion in the process of manufacturing products and outflows, whereby controlling the thickness of the product becomes difficult.

The graft copolymer (b) is prepared by grafting 5 to 30 parts by mass of a polymer formed with an aromatic vinyl monomer to 70 to 95 parts by mass of the second matrix polymer.

A sea-island structure in which islands of the graft copolymer (b) are dispersed in the graft copolymer (a) is formed, thereby imparting high folding endurance to the resin composition. However, when the aromatic vinyl monomer is less than 5 parts by mass, the sea-island structure is not formed sufficiently, and thus expected effects of enhancing folding endurance cannot be obtained. On the other hand, when the aromatic vinyl monomer is more than 30 parts by mass, the graft copolymer (b) that has extremely low flowability is prepared. It is difficult to knead such a graft copolymer (b) with the graft copolymer (a).

The side chains of the graft copolymer (b) are constituted of a polymer derived from aromatic vinyl monomers. The aromatic vinyl monomers may contain multifunctional aromatic vinyl monomers. The ratio of the multifunctional aromatic vinyl monomers in the aromatic vinyl monomers is generally 0 to 30 mass %, and preferably 10 to 20 mass %. When the multifunctional aromatic vinyl monomers are more than 30 mass % in the aromatic vinyl monomers, the graft copolymer (b) that has extremely low flowability is prepared. It is difficult to knead such a graft copolymer (b) with the graft copolymer (a).

A method for preparing the second matrix polymer will be explained. The second matrix polymer can be prepared by kneading 100 parts by mass of at least one monomer selected from nonpolar α-olefin monomers and nonpolar conjugated diene monomers, 11 to 67 parts by mass of an aromatic vinyl monomer, and 0.01 to 5 parts by mass of a radical polymerization initiator with a Banbury mixer.

As for a method of grafting for preparing the graft copolymer (b), the same method as with the graft copolymer (a) is desirably selected.

Manufacturing of the graft copolymer (b) according to the impregnation graft polymerization method will be described.

100 parts by mass of the second matrix polymer is suspended in water to prepare an aqueous suspension. One, two or more radical copolymerizable organic peroxides, and a radical polymerization initiator in which the temperature at which half of the initiator decomposes for 10 hours (the 10-hour half life temperature) is 40 to 90 degrees Celsius are dissolved in 5 to 43 parts by mass of an aromatic vinyl monomer to prepare a solution of the aromatic vinyl monomer. The radical copolymerizable organic peroxides are controlled to be 0.1 to 10 parts by mass to 100 parts by mass of the aromatic vinyl monomer. The radical polymerization initiator is controlled to be 0.01 to 5 parts by mass to 100 parts by mass of the total of the aromatic vinyl monomer and the radical copolymerizable organic peroxides.

The solution of the aromatic vinyl monomer is mixed with the aqueous suspension, and then, this aqueous suspension is heated under conditions that the radical polymerization initiator substantially does not decompose to copolymerize the aromatic vinyl monomer and the radical copolymerizable organic peroxides in the particles of the second matrix polymer to prepare a grafted precursor. The grafted precursor is melted and kneaded at 100 to 300 degrees Celsius to prepare the graft copolymer (b).

Method for kneading the graft copolymer (a) and the graft copolymer (b) is not particularly restricted, and there is a method using a Banbury mixer having a heating function and a kneading function, a pressure kneader, a roll, a single or twin screw extruder. A method in which a twin screw extruder is used, a graft copolymer, an anti-oxidizing agent, and a fire retardant additive are fed from a main hopper, melted and kneaded, then a rod like molded article being extruded from dies is passed through a pelletizer to form pellets is preferable because it is convenient and inexpensive. As for the temperature for the melting and kneading, the melting and kneading may be conducted at a temperature in which the graft copolymer (a) softens sufficiently. And the temperature is generally in the range of 150 to 300 degrees Celsius.

The resin composition can be prepared by mixing the precursor of the graft copolymer (a) with the precursor of the graft copolymer (b) and simultaneously conducting grafting of the precursors and kneading.

To the resin composition, standard additives such as a lubricant, a plasticizing agent, a nucleator, an ultraviolet screening agent, a coloring agent, or a fire retardant additive may be added without going out of the object of the present invention. In kneading the resin composition and the additives, without limitation, there may be used a Banbury mixer having a heating function and a kneading function, a pressure kneader, a roll, a single or twin screw extruder. Particularly preferable is the twin screw extruder. With the same conditions as the case of preparing the resin composition, the resin composition to which the additives are added can be prepared.

### <Manufacturing of films for printed wiring boards>

Films for printed wiring boards can be manufactured by molding the resin composition. As a molding method, the T-die method, the inflation molding method, the calender rolling method, or the press molding method, which are generally known, may be used. A preferred molding method is the calender rolling method. Conducting the calender roll molding at a temperature higher than the melting point of the resin composition by 20 to 30 degrees Celsius makes it possible to form a film having a uniform thickness and suitable for manufacturing printed wiring boards.

### <Manufacturing of flexible printed wiring boards>

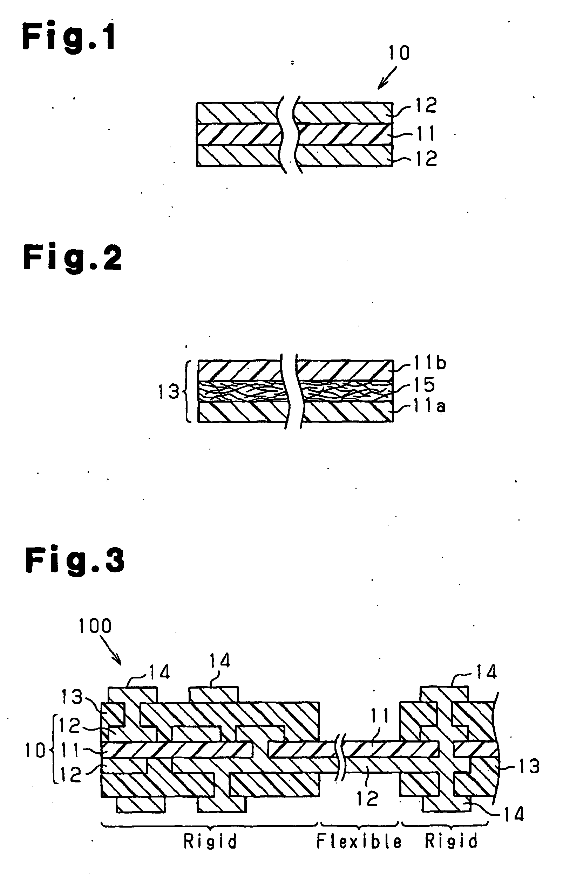

As shown in Fig. 1, a flexible printed wiring board 10 includes an electrical insulative resin film 11 (the printed wiring board film) made of the resin composition according to the preferred embodiment and a conductive layer 12, such as a metal layer, in which electrical circuits are formed. In the illustrated embodiment, the electrical insulative resin film 11 is sandwiched between two conductive layers 12. The thicknesses of the components in Fig. 1 are not to scale.

A flexible printed wiring board can be manufactured by subjecting a surface of an electrical insulative resin film (the printed wiring board film) made of the resin composition according to the preferred embodiment to a plating treatment to form a conductive layer. Alternatively, a flexible printed wiring board can be manufactured by subjecting the printed wiring board film that is sandwiched by conductive layers to the vacuum press method or the belting press method. In terms of easy manufacturing, the vacuum press method is preferable.

As a material for the conductive layer to be used for a flexible printed wiring board, a metal foil made of a metal or an alloy such as copper, aluminum, iron, nickel, or zinc may be used. In case of necessity, the surface of the conductive layer may be subjected to a corrosion prevention treatment with metals such as chromium or molybdenum. The conductive layer may be manufactured by known techniques such as the electrolytic method or rolling method. The conductive layer generally has a thickness of about 0.003 to 1.5 mm. A metal layer functioning as the conductive layer can be formed directly on the outer layer of the printed wiring board film by the vacuum deposition method or the plating method.

### <Manufacturing of rigid flexible printed wiring boards>

Fig. 3 shows an example of a rigid flexible printed wiring board 100 including a flexible board portion bridging rigid board portions. The rigid board portions are formed from a flexible printed wiring board 10 and a prepreg 13. The flexible board portion is formed from the flexible printed wiring board 10.

The flexible printed wiring board 10 includes an electrical insulative resin film 11 (a first printed wiring board film) made of the resin composition according to the preferred embodiment and a conductive layer 12, such as a metal layer, in which electrical circuits are formed.

As shown in Fig. 2, the prepreg 13 includes a sheet-like, fiber-reinforced material 15, such as a glass cloth, and at least one electrical insulative resin film (a second printed wiring board film) made of the resin composition according to the preferred embodiment, thermal pressure adhered to the sheet-like, fiber-reinforced material 15. In the illustrated example, the sheet-like, fiber-reinforced material 15 is sandwiched by two electrical insulative resin films 11a and 11b. One of the electrical insulative resin films 11a and 11b may be omitted. A conductive layer for forming electrical circuits 14 can be formed on a major surface or both major surfaces of the prepreg 13. In the illustrated example, two conductive layers 12a and 12b are formed on the two major surfaces of the prepreg 13. Via holes (thorough holes) may be formed in the prepreg 13.

The flexible printed wiring board 10 is thermal pressure adhered to the prepreg 13 so that electrical circuits of the conductive layer 12 are connected to the electrical circuits 14.

The prepreg can be manufactured by subjecting the film of the resin composition and the sheet-like, fiber-reinforced material, such as a glass fiber-reinforced material, to thermal pressure adhesion. The glass fiber-reinforced material is an inorganic material that imparts a given rigidity to the prepreg. An example of the glass fiber-reinforced material is a glass cloth. The glass cloth is a reinforced film woven with filaments of a glass material. The amounts of the glass fiber-reinforced material is desirably 2 mass % to 40 mass % in the prepreg, and more desirably 10 to 30 mass %. When the amounts are less than 2 mass %, at the time of subjecting a film of the resin composition and the glass fiber-reinforced material to thermal pressure adhesion, the film softened by heat cannot be held and thus it is difficult to form the prepreg. On the other hand, when the amounts are more than 40 mass %, low dielectric constant and low dielectric loss in high-frequency bands of the prepreg are considerably impaired.

By bonding the prepreg and the flexible printed wiring board, a rigid flexible printed wiring board made from the same material can be manufactured. More specifically, first, a metal foil such as copper is subjected to thermal pressure adhesion to each surface of the prepreg. The metal foils are etched to form electrical circuits. Consequently, a board on which the electrical circuits are formed is manufactured. This board functions as a rigid board portion (see Fig. 3).

In addition, an electrical circuit is formed on the flexible printed wiring board in a like manner. The rigid board and the flexible board are subjected to thermal pressure adhesion under conditions that misregistration does not occur between the circuit on the rigid board and the circuit on the flexible board to bond the boards each other.

By using a flexible board and plural rigid boards, a rigid flexile printed circuit board can be manufactured in which the rigid boards are bonded by the flexible board. By manufacturing a rigid flexible printed wiring board from the same material as a flexible printed wiring board; high-frequency electrical characteristics of each material can be fully exhibited, each wiring board can be easily processed and manufacturing processes of each wiring board can be simplified.

Thus manufactured resin composition, flexible printed wiring board, and rigid flexible printed wiring board have excellent electrical characteristics (low dielectric constant and low dielectric loss) in high-frequency bands and high folding endurance, and thus can be preferably used for electronic circuits that transmit signals in high-frequency bands.

A resin composition according to the preferred embodiments is prepared by mixing 80 to 99.5 mass % of the graft copolymer (a) and 0.5 to 20 mass % of the graft copolymer (b). The matrix of each graft copolymer is substantially nonpolar, and does not include polar groups having high dipole moment. Therefore, the resin composition has enhanced electrical insulating properties and enhanced dielectric properties in high-frequency bands.

It has been believed that the graft copolymer (a) has excellent mechanical properties thereby being suitable for manufacturing rigid printed wiring boards, however not suitable for manufacturing bendable printed wiring boards such as a flexible printed wiring board or a rigid flexible printed wiring board. This reason is as follows. In the graft copolymer (a), "60 to 85 parts by mass of a random or block copolymer comprising monomer units selected from nonpolar α-olefin monomers and nonpolar conjugated diene monomers" function as a continuous phase (a main chain), and "15 to 40 parts by mass of an aromatic vinyl monomer" function as a domain phase (a side chain). Compatibility between the continuous phase and the domain phase is insufficient and thus detachment tends to occur at the interface of the phases. The detachment is one of the causes that generate cracks of bendable printed wiring boards.

However, according to the preferred embodiments, it has been established that blending the graft copolymer (b) with the graft copolymer (a) provides a resin composition that has a sufficient flexibility and with which a printed wiring board film endurable of repeated stress is manufactured. This reason is estimated that both of the main chain and the side chain of the graft copolymer (b) have an aromatic vinyl monomer unit, the aromatic vinyl monomer unit of the graft copolymer (b) provides compatibility with both of the main chain and the side chain of the graft copolymer (a), and the graft copolymer (b) is dispersed to make the main chain and the side chain of the graft copolymer (a) compatible.

According to the preferred embodiments, the following advantages are obtained.

A resin composition according to the preferred embodiments comprises two types of graft copolymers (a) and (b), and the graft copolymer (a) is 80 to 99.5 mass % and the graft copolymer (b) is 0.5 to 20 mass %. The matrix of each of graft copolymer (a) and (b) is substantially nonpolar, and thus transmission characteristics of electrical signals in high-frequency bands can be maintained excellently. In addition, by combining the graft copolymer (b) with the graft copolymer (a), the graft copolymer (b) makes the main chain and the side chain of the graft copolymer (a) compatible, whereby a printed wiring board film having excellent folding endurance can be manufactured.

A flexible printed wiring board is manufactured by forming a printed wiring board film with the resin composition and providing a conductive layer on either or both of the two surfaces of the film. Therefore, a flexible printed wiring board that exhibits the above mentioned effects can be manufactured.

A rigid flexible printed wiring board is constituted by preparing a prepreg with the resin composition along with preparing a flexible printed wiring board with the resin composition, and bonding the prepreg and the flexible printed wiring board. Therefore, the rigid flexible printed wiring board exhibits the above mentioned effects.

Hereinafter, Reference Examples, Examples, and Comparative Examples will be explained.

First, test methods for printed wiring boards will be explained.

### <Transmission characteristics>

The transmission characteristics of a resin composition used for forming a printed wiring board film were evaluated by transmission loss of signals passing through circuits formed on the film. Specifically, the evaluation was conducted by the value of transmission loss (dB/cm) in the case of passing signals at a frequency of 10 GHz through a microstripline having a width of 1 mm and a length of 83 mm obtained by etching a flexible printed wiring board manufactured by using the film.

In consideration of use in high-frequency bands, transmission loss at a frequency of 10 GHz is preferably 0 to -0.1 dB/cm, and more preferably 0 to -0.08 dB/cm. When the transmission loss at a frequency of 10 GHz is more than 0 dB/cm, deterioration of information passing through circuits, malfunctions due to heat generated from circuits, and so on can be expected. In addition, in order to reduce crosstalk, it is necessary to make spacing between circuits wide, and which becomes one of the causes that hamper miniaturization of parts and devices.

### <Folding endurance>

As for a flexible printed wiring board and a flexible printed wiring board portion of a rigid flexible printed wiring board, folding endurance was evaluated. Specifically, folding endurance of a film formed with a resin composition was evaluated with values obtained in accordance with JIS C6471: 1994 "Test methods of copper-clad laminates for flexible printed wiring boards". In consideration of use as a flexible printed wiring board, the folding endurance is preferably 500 times or more, and more preferably 1000 times or more. When the folding endurance of a flexible printed wiring board is less than 500 times, circuits can have breaks by repeated folding in actual use.

Next, methods for preparing a polymer material used in each example are shown as Reference Examples.

### (Reference Example 1, preparation of graft copolymer (a))

2500 g of pure water was added to a stainless autoclave having an internal volume of 5 L, and then 2.5 g of polyvinyl alcohol was dissolved therein as a suspending agent. Then 700 g of polypropylen was added thereto, stirred and dispersed. Aside from this, 2.0 g of benzoyl peroxide as a radical polymerization initiator and 7.5 g of t-butyl peroxymethacryloyloxyethyl carbonate as a radical copolymerizable organic peroxide were dissolved in 100 g of divinylbenzene and 200 g of styrene which are aromatic vinyl monomers. This solution was introduced in the autoclave and stirred.

Then the temperature of the autoclave was raised to 85 to 95 degrees Celsius and stirred for 2 hours to impregnate the aromatic vinyl monomers containing the radical polymerization initiator and the radical polymerizable organic peroxide into polypropylen. Then the temperature was decreased to 75 to 85 degrees Celsius and the temperature was kept for 5 hours to complete polymerization. This solution was filtered, then washed with water and dried to obtain a grafted precursor. Then this grafted precursor was extruded with Labo Plastomill monoaxial extruder (manufactured by Toyo Seiki Seisaku-sho, Ltd.) at 210 degrees Celsius and subjected to graft reaction to obtain a graft copolymer (a).
PP: polypropylene: "SunAllomer PM671A" (product name, manufactured by SunAllomer Ltd.) (MFR: 7 g/(10 min))
Benzoyl peroxide: "NYPER BW" (product name, manufactured by NOF CORPORATION, purity: 75%, hydrous compound)
t-butyl peroxymethacryloyloxyethyl carbonate: manufactured by NOF CORPORATION, a 40% toluene solution

### (Reference Examples 2 to 7)

By using the method as with Reference Example 1, thermoplastic resins belonging to various matrix polymers and the graft copolymers (a) derived from aromatic vinyl monomers were prepared. The compositions thereof are shown in Table 1.

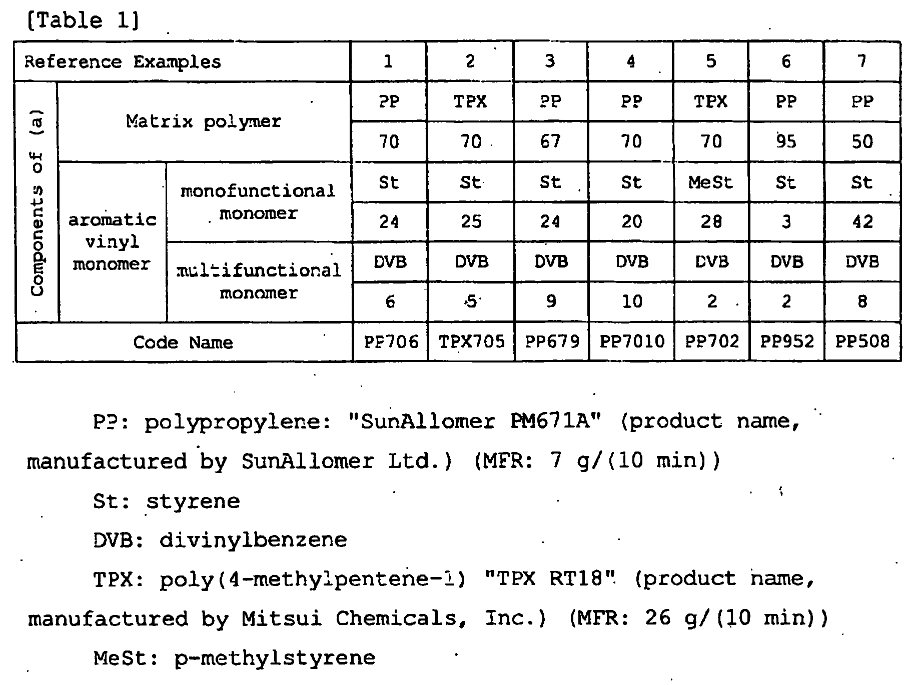

### (Reference Example 8, manufacturing of graft copolymer (b))

4900 g of SBR (1), 100 g of divinylbenzene and 6.5 g of benzoyl peroxide were kneaded with a Banbury mixer under a nitrogen atmosphere at 200 degrees Celsius for 5 minutes to prepare pellets of a resin composition. This resin composition belongs to the second matrix polymer.

SBR (1): styrene-butadiene rubber "Nipo19526" (product name, manufactured by ZEON Corporation) (Mooney viscosity: 38)

Subsequently to a stainless autoclave having an internal volume of 5 L in which 2.5 g of polyvinyl alcohol was dissolved in 2500 g of pure water, 900 g of the second matrix polymer was added, stirred and dispersed. Aside from this, 0.8 g of benzoyl peroxide as a radical polymerization initiator and 3.0 g of t-butyl peroxymethacryloyloxyethyl carbonate as a radical copolymerizable organic peroxide were dissolved in 20 g of divinylbenzene and 80 g of styrene which are aromatic vinyl monomers. This solution was introduced in the autoclave and stirred. Then the temperature of the autoclave was raised to 85 to 95 degrees Celsius and stirred for 2 hours to impregnate the aromatic vinyl monomers containing the radical copolymerization initiator and the radical polymerizable organic peroxide into polypropylen. Then the temperature was decreased to 75 to 85 degrees Celsius and the temperature was kept for 5 hours to complete polymerization. This solution was filtered, then washed with water and dried to obtain a grafted precursor. Then this grafted precursor was extruded with Labo Plastomill monoaxial extruder (manufactured by Toyo Seiki Seisaku-sho, Ltd) at 210 degrees Celsius and subjected to graft reaction to obtain a graft copolymer (b).

### (Reference Examples 9 to 14)

By using the method as with Reference Example 8, various second matrix polymers were prepared. The various second matrix polymers are shown in Table 2. And commercially available resins that can be used as the second matrix polymers are shown in Table 3. In addition, by using the second matrix polymers shown in Table 2 and 3, thermoplastic resins belonging to the graft copolymers (b) derived from the second matrix polymers and aromatic vinyl monomers were prepared. The compositions thereof are shown in Table 4.

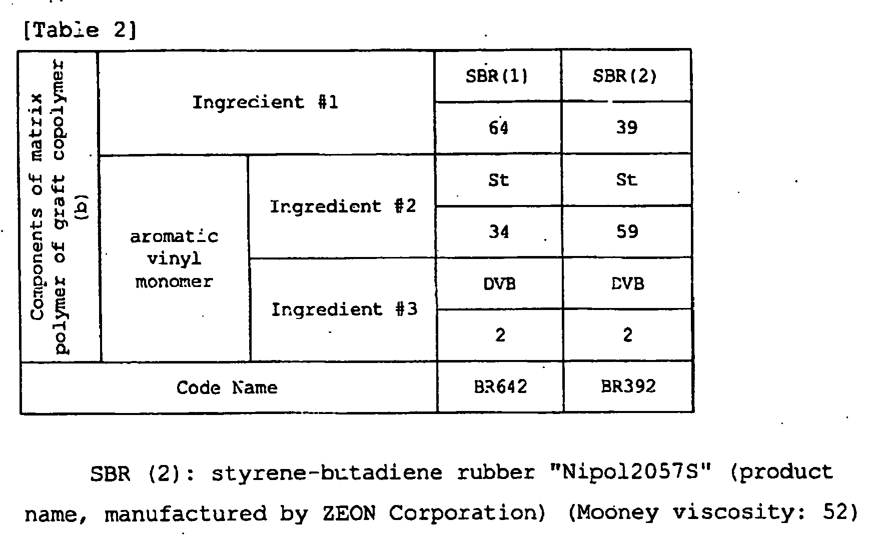

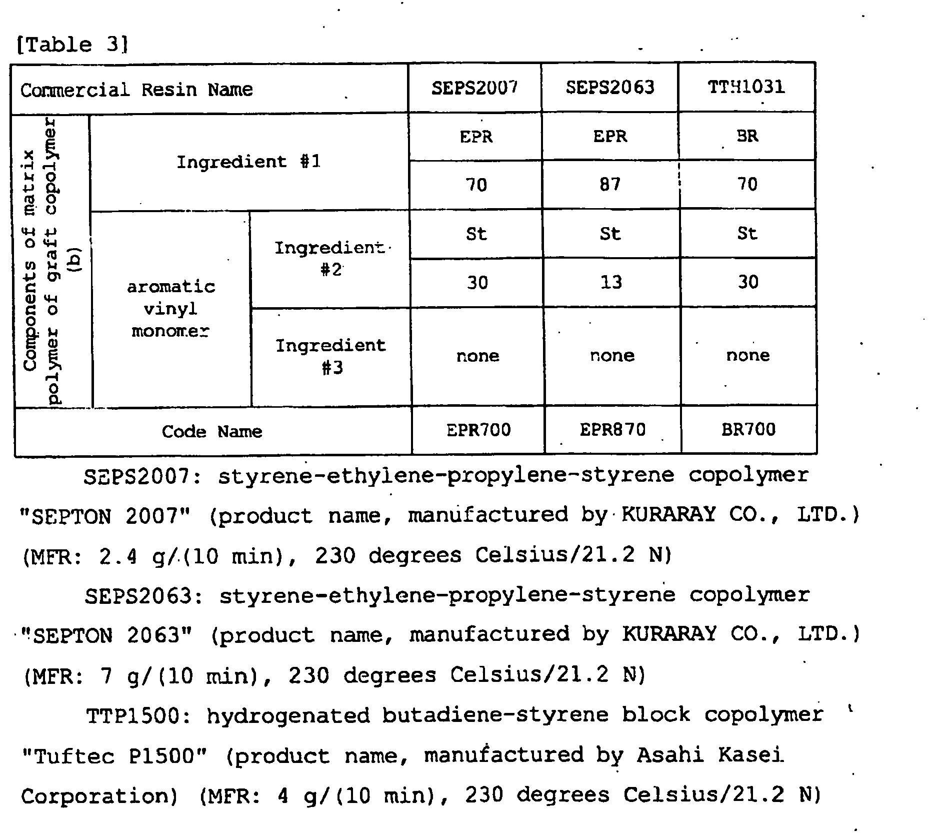

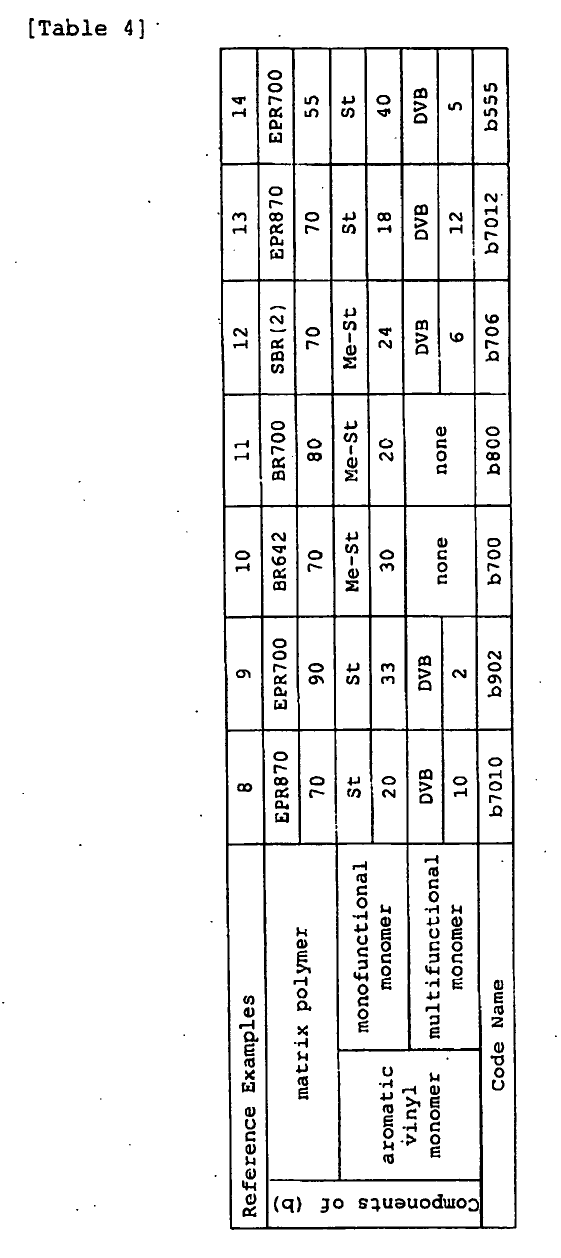

### (Example 1)

Dry blend was conducted of 45 kg of the graft copolymer in Reference Example 1, 5 kg of the graft copolymer in Reference Example 9, and as anti-oxidizing agents of the graft copolymers, 100 g of 1,3,5-trimethyl-2,4,6-tris(3,5-di-t-butyl-4-hydroxybenzyl) benzene and 100 g of neopentane tetraylbis (2,6-di-t-butyl-4-methylphenyl) phosphite. Then this mixture was fed to a coaxial twin-screw extruder (TEX-30a, manufactured by The Japan Steel Works, LTD.) having a screw diameter of 30 mm and in which the cylinder temperature was controlled to be 210 degrees Celsius. After the extrusion, granulation was conducted to prepare a resin composition to be used for forming a resin film. Then the resin composition was rolled with calender roll equipment (manufactured by Nippon Roll MFG. Co., Ltd.) at 170 degrees Celsius to obtain a resin film used for a printed wiring board.

The both surfaces of the resin film were subjected to surface modification with UV-03 treatment device (manufactured by Sen Engineering Co., Ltd.). Then the resin film was sandwiched between two sheets of 18 µm thick rolled copper foils (manufactured by Fukuda Metal Foil & Powder Co., Ltd.) and subjected to thermal pressure adhesion with a vacuum pressing machine at 200 degrees Celsius to manufacture a board for a flexible printed wiring board.

1,3,5-trimethyl-2,4,6-tris(3,5-di-t-butyl-4-hydroxybenzyl) benzene: "Irganox 1330" (product name, manufactured by Ciba Specialty Chemicals)

Neopentanetetraylbis (2,6-di-t-butyl-4-methylphenyl) phosphite: "ADK STAB PEP-36" (product name, manufactured by ADEKA CORPORATION)

### (Examples 2 to 7)

By kneading the various graft copolymers (a) shown in Table 1 with the various graft copolymers (b) shown in Table 4, various resin compositions used for forming resin films for printed wiring boards and flexible printed wiring boards were manufactured. As for these, each transmission loss and folding endurance in high-frequency bands are shown in Table 5.

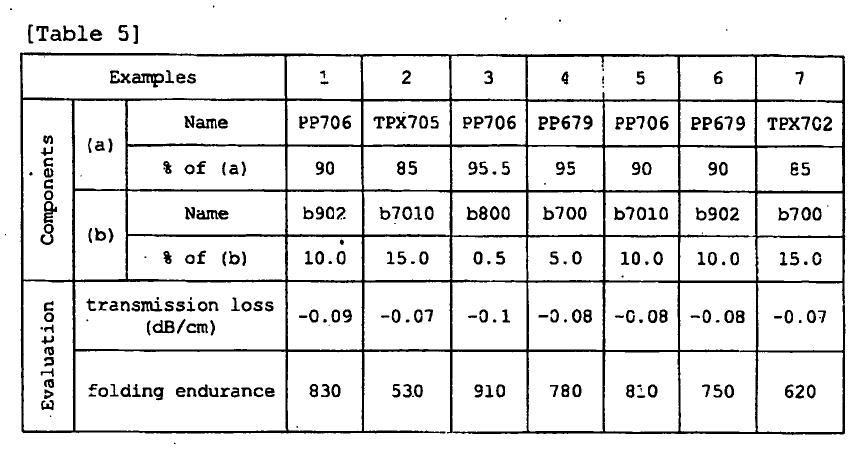

From the results shown in Table 5, the resin films formed with resin compositions shown in Examples 1 to 7 and double-sided copper clad substrates thereof have a transmission loss at a frequency of 10 GHz of as small as 0 to -1.0 dB/cm, and exhibits excellent folding endurance. Therefore, the resin films are suitably used for flexible printed wiring boards.

### (Example 8)

A glass cloth "#1067" was sandwiched between two sheets of the resin films in Example 1, and subjected to thermal pressure adhesion with a vacuum pressing machine at 200 degrees Celsius to obtain a prepreg. In addition, the both surfaces of the prepreg were subjected to surface modification with the UV-03 treatment device. Then the prepreg was sandwiched between two sheets of 18 µm thick rolled copper foils and subjected to thermal pressure adhesion with a vacuum pressing machine at 200 degrees Celsius to obtain a rigid double-sided metal clad board. Circuit patterns were formed on this double-sided metal clad board and the metal clad board for a flexible printed wiring board obtained in Example 1 to manufacture a rigid printed wiring board and a flexible printed wiring board. A location of the band-like flexible printed wiring board were sandwiched between two sheets of the rigid printed wiring boards and subjected to thermal pressure adhesion with a vacuum pressing machine at 200 degrees Celsius to obtain a rigid flexible printed wiring board.

Each of the resin compositions is a thermoplastic graft copolymer and also flowability thereof does not change steeply in temperatures more than or equal to the melting point. Therefore, such a resin composition does not cause misregistration of a circuit pattern, variation of thickness, and change in dimensions, and thus suitable for processing boards that requires repeated laminating steps such as a rigid flexible printed wiring board.

#1067: glass cloth (style number, manufactured by Asahi-Schwebel) (specific gravity: 31 g/m², thickness: 32 µm)

### (Comparative Examples 1 to 7)

By kneading the various graft copolymers (a) shown in Table 1 with the various graft copolymers (b) shown in Table 4, various resin films to be used for printed wiring boards and flexible printed wiring boards were manufactured by using the method as with Example 1. As for these, each transmission loss and folding endurance in high-frequency bands are shown in Table 6.

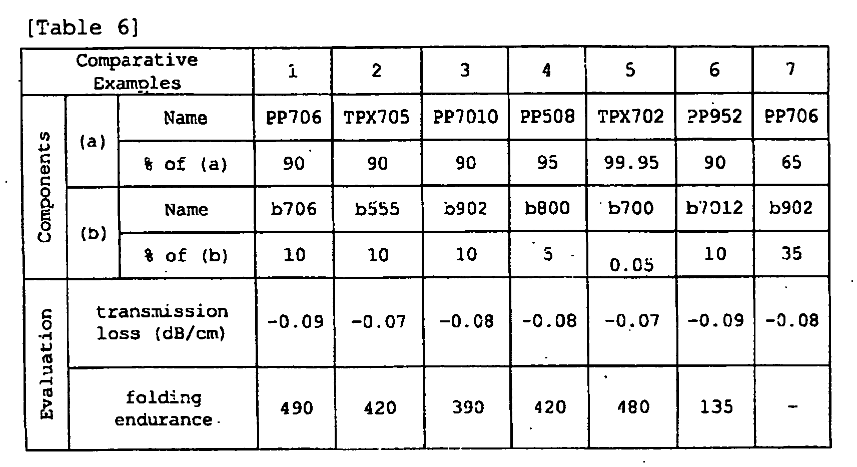

As shown in Table 6, Comparative Example 1 lacked folding endurance because resins of the matrix polymer for the resin used for the graft copolymer (b) was constituted of the large ratio of the aromatic vinyl monomers. Comparative Example 2 lacked folding endurance because the graft copolymer (b) was constituted of the large ratio of the aromatic vinyl monomers. Comparative Example 3 had further lower folding endurance because segments derived from the aromatic vinyl monomers that constituted the graft copolymer (a) contained a large ratio of the multifunctional aromatic vinyl monomer.

Comparative Example 4 lacked folding endurance because of the large ratio of segments derived from the aromatic vinyl monomers that constituted the graft copolymer (a). Comparative Example 5 lacked folding endurance because the ratio of the graft copolymer (b) was small and effects of the graft copolymer (b) were not expressed. In Comparative Example 6, folding endurance was lowered significantly because both the graft copolymer (a) and the graft copolymer (b) had the large ratios of aromatic vinyl monomers and consequently the resin film became very brittle. In Comparative Example 7, it was impossible to form a circuit itself because the graft copolymer (b) was excessive in comparison with the graft copolymer (a) and the resin film outflowed at the time of subjecting metal foils to thermal pressure adhesion to the resin film because of high flowability.

### (Comparative Examples 8 and 9)

By subjecting resin films belonging to the graft copolymer (a) to the method as with Example 1, various resin compositions and flexible printed wiring boards were manufactured. And as to copper clad boards made of polyimide, each transmission characteristics and folding endurance were evaluated. Evaluation results of transmission characteristics and folding endurance of each board are shown in Table 7.

PI: copper clad polyimide film "1F1-RN10" (manufactured by Toray Industries, Inc.)

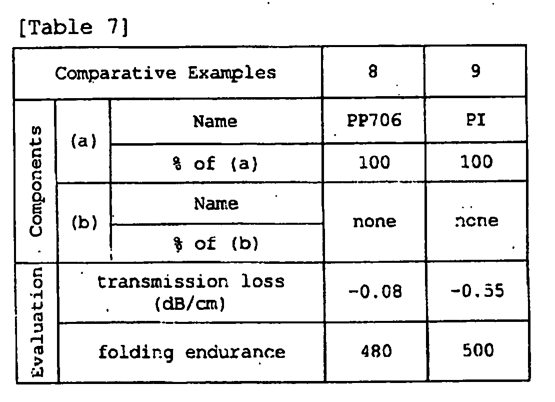

From the results in Table 7, both Comparative Examples 8 and 9 lacked folding endurance.

It should be apparent to those skilled in the art that the present invention may be embodied in many other specific forms without departing from the spirit or scope of the invention. Particularly, it should be understood that the present invention may be embodied in the following forms.

In the graft copolymer (a) and the graft copolymer (b), nonpolar α-olefin monomers and nonpolar conjugated diene monomers may be used in combination.

In the graft copolymer (a) and the graft copolymer (b), the random copolymer and the block copolymer may be used in combination.

## Claims

1. A resin composition for a printed wiring board film, the resin composition comprising:
- 80 to 99.5 mass % of a component (a); and
- 0.5 to 20 mass % of a component (b),
wherein the component (a) is a graft copolymer in which 15 to 40 mass % of an aromatic vinyl monomer are grafted as side chain(s) to 60 to 85 mass % of a random or block copolymer main chain composed of polymerized monomer units selected from nonpolar α-olefin monomers and nonpolar conjugated diene monomers, wherein an amount of multifunctional aromatic vinyl monomer in the aromatic vinyl monomer (side chains) of the graft copolymer component (a) is 2 to 30 mass %; and
the component (b) is a graft copolymer in which 5 to 30 mass % of an aromatic vinyl monomer are grafted as side chain(s) to 70 to 95 mass % of a random or block copolymer composed of 60 to 90 mass % of a monomer unit, which is selected from nonpolar α-olefin monomers and nonpolar conjugated diene monomers polymerized with 10 to 40 mass % of an aromatic vinyl monomer unit.

2. The resin composition according to claim 1, wherein the aromatic vinyl monomer for preparing the component (a) or the component (b) is a styrene monomer.

3. The resin composition according to claim 1, wherein the components (a) and (b) are free of polar functional groups or polar skeletons.

4. The resin composition according to claim 1, which is thermoplastic and electrical insulative.

5. A flexible printed wiring board, comprising:
- a printed wiring board film, which is made from the resin composition of claim 1 and includes two major surfaces; and
- a conductive layer laminated on at least one of the two major surfaces of the printed wiring board film.

6. The flexible printed wiring board according to claim 5, wherein the conductive layer is a metal foil in which an electrical circuit is formed.

7. A rigid flexible printed wiring board, comprising:
- a prepreg including a first printed wiring board film, which is made from the resin composition of claim 1, and a sheet-like, fiber-reinforced material thermal pressure adhered to the first printed wiring board film; and
- a flexible printed wiring board including a second printed wiring board film, which is made from the resin composition of claim 1 and includes two major surfaces, and a conductive layer laminated on at least one of the two major surfaces of the second printed wiring board film.

8. The rigid flexible printed wiring board according to claim 7, wherein the sheet-like, fiber-reinforced material is a glass cloth.

9. The rigid flexible printed wiring board according to claim 7, wherein the conductive layer is a metal foil in which an electrical circuit is formed.

10. The rigid flexible printed wiring board according to claim 7, wherein the first printed wiring board film is one of two first printed wiring board films, and the sheet-like, fiber-reinforced material is sandwiched by the two first printed wiring board films.

11. The rigid flexible printed wiring board according to claim 7, further comprising a conductive layer formed on the first printed wiring board film of the prepreg and including an electrical circuit.

## Patentansprüche

1. Eine Harzzusammensetzung für eine gedruckte Leiterplattenfolie, wobei die Harzzusammensetzung umfasst:
- 80 bis 99,5 Gew.% einer Komponente (a); und
- 0,5 bis 20 Gew.% einer Komponente (b),
wobei die Komponente (a) ein Pfropfcopolymer ist, in dem 15 bis 40 Gew.% eines aromatischen Vinylpolymers als Seitenkette(n) an 60 bis 85 Gew.% einer zufälligen oder Block-Copolymer-Hauptkette gepfropft sind, die aus polymerisierten Monomereinheiten zusammengesetzt ist, die ausgewählt werden aus nicht-polaren α-Olefin Monomeren und nicht-polaren, konjugierten Dien Monomeren, wobei die Menge an multifunktionalem aromatischem Vinyl Monomer in dem aromatischen Vinyl Monomer(Seitenketten) der Pfropfcopolymerkomponente (a) 2 bis 30 Gew.% beträgt; und
die Komponente (b) ein Pfropfcopolymer ist, in dem 5 bis 30 Gew.% eines aromatischen Vinyl Monomers als Seitenkette(n) auf 70 bis 95 Gew.% eines zufälligen oder BlockCopolymers gepfropft werden, das aus 60 bis 90 Gew.% einer Monomereinheit zusammengesetzt ist, die ausgewählt wird aus nicht-polaren α-Olefin Monomeren und nicht-polaren konjugierten Dien Monomeren, die mit 10 bis 40 Gew.% einer aromatischen Vinyl Monomereinheit polymerisiert sind.

2. Die Harzzusammensetzung nach Anspruch 1, wobei das aromatische Vinyl Monomer zur Herstellung der Komponente (a) oder der Komponente (b) ein Styrol Monomer ist.

3. Die Harzzusammensetzung nach Anspruch 1, wobei die Komponenten (a) und (b) frei von polaren funktionalen Gruppen oder polaren Gerüsten sind.

4. Die Harzzusammensetzung nach Anspruch 1, die thermoplastisch und elektrisch isolierend ist.

5. Eine flexible gedruckte Leiterplatte, die umfasst:
- eine gedruckte Leiterplattenfolie, die aus der Harzzusammensetzung gemäß Anspruch 1 hergestellt wird und zwei Hauptoberflächen umfasst; und
- eine leitende Schicht, die auf mindestens eine der zwei Hauptoberflächen der gedruckten Leiterplattenfolie laminiert ist.

6. Die flexible gedruckte Leiterplatte gemäß Anspruch 5, wobei die leitende Schicht aus einer Metallfolie besteht, in welcher ein elektrischer Schaltkreis ausgebildet ist.

7. Eine starre, flexible gedruckte Leiterplatte, die umfasst:
- ein Prepreg, das eine erste flexible gedruckte Leiterplattenfolie, die aus der Harzzusammensetzung gemäß Anspruch 1 hergestellt ist, und ein blattähnliches, faserverstärktes Material, das durch thermischen Druck an die erste gedruckte Leiterplattenfolie angeheftet wurde, einschließt; und
- eine flexible gedruckte Leiterplatte, die eine zweite gedruckte Leiterplattenfolie einschließt, die aus der Harzzusammensetzung gemäß Anspruch 1 hergestellt ist und zwei Hauptoberflächen und eine leitende Schicht, die auf mindestens eine der beiden Hauptoberflächen der zweiten gedruckten Leiterplattenfolie laminiert ist, einschließt.

8. Die starre, flexible gedruckte Leiterplatte gemäß Anspruch 7, wobei das blattähnliche, faser-verstärkte Material ein Glasfasergewebe ist.

9. Die starre, flexible gedruckte Leiterplatte gemäß Anspruch 7, wobei die leitende Schicht eine Metallfolie ist, in der ein elektrischer Schaltkreis ausgebildet ist.

10. Die starre, flexible gedruckte Leiterplatte gemäß Anspruch 7, wobei die erste gedruckte Leiterplattenfolie eine von zwei ersten gedruckten Leiterplattenfolien ist und das blattähnliche, faser-verstärkte Material zwischen den zwei ersten gedruckten Leiterplattenfolien liegt.

11. Die starre, flexible gedruckte Leiterplatte gemäß Anspruch 7, die ferner eine leitende Schicht umfasst, die auf der ersten gedruckten Leiterplattenfolie des Prepregs ausgebildet wird und einen elektrischen Schaltkreis einschließt.

## Revendications

1. Composition de résine pour un film de carte à circuit imprimé, la composition de résine comprenant :
- 80 % à 99,5 % en masse d'un composant (a) ; et
- 0,5 % à 20 % en masse d'un composant (b),
où le composant (a) est un copolymère greffé dans lequel 15 % à 40 % en masse d'un monomère de vinyle aromatique sont greffés en tant que chaîne(s) latérale(s) à 60 % à 85 % en masse d'une chaîne principale de copolymère statistique ou séquencé composée d'unités monomères polymérisées choisies parmi des monomères d'alpha-oléfines non polaires et des monomères diènes conjugués non polaires, où une quantité de monomère de vinyle aromatique multifonctionnel dans le monomère de vinyle aromatique (chaînes latérales) du composant de copolymère greffé (a) est de 2 % à 30 % en masse ; et
le composant (b) est un copolymère greffé dans lequel 5 % à 30 % en masse d'un monomère de vinyle aromatique sont greffés en tant que chaîne(s) latérale(s) à 70 % à 95 % en masse d'un copolymère statistique ou séquencé composé de 60 % à 90 % en masse d'une unité de monomère, qui est choisie parmi des monomères d'alpha-oléfines non polaires et des monomères diènes conjugués non polaires polymérisées avec 10 % à 40 % en masse d'une unité de monomère de vinyle aromatique.

2. Composition de résine selon la revendication 1, dans laquelle le monomère de vinyle aromatique pour préparer le composant (a) ou le composant (b) est un monomère de styrène.

3. Composition de résine selon la revendication 1, dans laquelle les composants (a) et (b) sont dépourvus de groupes fonctionnels polaires ou de squelettes polaires.

4. Composition de résine selon la revendication 1, qui est thermoplastique et électriquement isolante.

5. Carte à circuit imprimé flexible, comprenant :
- un film de carte à circuit imprimé, qui est préparé à partir de la composition de résine de la revendication 1 et inclut deux surfaces principales ; et
- une couche conductrice stratifiée sur au moins l'une des deux surfaces principales du film de carte à circuit imprimé.

6. Carte à circuit imprimé flexible selon la revendication 5, dans laquelle la couche conductrice est une feuille de métal dans laquelle un circuit électrique est formé.

7. Carte à circuit imprimé flexible rigide, comprenant :
- un pré-imprégné incluant un premier film de carte à circuit imprimé, qui est préparé à partir de la composition de résine de la revendication 1, qui est un matériau en forme de feuille renforcé par des fibres collé par pression à chaud au premier film de carte à circuit imprimé ; et
- une carte à circuit imprimé flexible incluant un deuxième film de carte à circuit imprimé, qui est préparé à partir de la composition de résine de la revendication 1 et inclut deux surfaces principales, et une couche conductrice stratifiée sur au moins l'une des deux surfaces principales du deuxième film de carte à circuit imprimé.

8. Carte à circuit imprimé flexible rigide selon la revendication 7, dans laquelle le matériau en forme de feuille renforcé par des fibres est un tissu de verre.

9. Carte à circuit imprimé flexible rigide selon la revendication 7, dans lequel la couche conductrice est une feuille de métal dans laquelle un circuit électrique est formé.

10. Carte à circuit imprimé flexible rigide selon la revendication 7, dans laquelle le premier film de carte à circuit imprimé est l'un des deux premiers films de carte à circuit imprimé, et le matériau en forme de feuille renforcé par des fibres est pris en sandwich par les deux premiers films de carte à circuit imprimé.

11. Carte à circuit imprimé flexible rigide selon la revendication 7, comprenant en outre une couche conductrice formée sur le premier film de carte à circuit imprimé du pré-imprégné et incluant un circuit électrique.
